Europäisches Patentamt

European Patent Office

Office européen des brevets

(11) Publication number: **0 416 763 A1**

# EUROPEAN PATENT APPLICATION

(21) Application number: 90308906.8

(22) Date of filing: 14.08.90

(51) Int. Cl.⁵: **C23G 5/02**

(30) Priority: 14.08.89 GB 8918504

(43) Date of publication of application:
13.03.91 Bulletin 91/11

(84) Designated Contracting States:
AT BE CH DE DK ES FR GB GR IT LI LU NL SE

(71) Applicant: BUSH BOAKE ALLEN LIMITED
Blackhorse Road Walthamstow
London E17 5QP(GB)

Applicant: ENVIROSOLV INC.
1840 Southside Boulevard
Jacksonville Florida 32216(US)

(72) Inventor: Keyser, Gene
2051 North Lane Avenue
Jacksonville, Florida 32205(US)
Inventor: Kass, Charles
1840 Southside, Boulevard
Jacksonville, Florida 32216(US)
Inventor: Curtis, Anthony
Bush Boake Allen Limited
Blackhorse Lane, London, E17 5QP(GB)

(74) Representative: Lawrence, Peter Robin
Broughton et al
GILL JENNINGS & EVERY 53-64 Chancery
Lane
London WC2A 1HN(GB)

(54) Methods and compositions for cleaning articles.

(57) Dirty articles such as printed circuit boards or other electronic components are cleaned by contact with a terpene or other non halogenated solvent and the resultant solvent contamination is removed by contacting the contaminated surface at an elevated temperature with steam or other aqueous medium and azeotropically evaporating the solvent contamination from the surface as an azeotrope.

## METHODS AND COMPOSITIONS FOR CLEANING ARTICLES

This invention relates to the cleaning of dirty articles while contained within a vessel. Such articles may be, for instance, relatively small metal, ceramic or glass articles, for instance circuit boards or machined parts.

It is routine practice to clean dirty surfaces by contacting them with an aqueous or non-aqueous liquid, and to promote the contact by forcing the liquid against the surfaces. Thus surfaces can be cleaned by water, often brushed on or applied as a jet, and then left to dry. Water is not very effective for removing organic residues but steaming is sometimes used.

Aqueous detergent compositions may remove organic residues but are liable to leave residues of detergents, necessitating thorough rinsing to remove these residues.

The most effective way of removing organic dirt from articles is therefore generally recognised as involving contacting the articles with organic solvents that will dissolve the residues. As a result there is extremely large capital investment in equipment for cleaning articles by contacting the articles with an organic solvent while the articles are held within a vessel. The contact can be by immersing the articles in liquid phase solvent or by exposing them to vapour phase solvent, generally at a relatively cool temperature such that the solvent condenses on to the articles.

The chosen solvent must have adequate solvency power for the residues that are to be removed, it must have a flash point sufficiently above the temperature of use that it is safe to use, and it preferably has a volatility such that it does not leave a residual film of solvent after use. Preferably therefore the solvent will evaporate relatively quickly when exposed to the ambient atmospheric temperature of, for instance, 30°C or below.

Low boiling hydrocarbons often have adequate solvency power and may be adequately volatile, but they suffer from the disadvantage that they have low flash point. Higher boiling hydrocarbons may have adequate solvency power and a reasonably safe flash point, but their volatility is sufficiently low that residues of them remain on the articles unless the articles are deliberately heated, but this is undesirable because of the risk of the temperature then approaching or exceeding the flash point.

Because of these difficulties, halogenated solvents have become widely accepted as cleaners that have suitable solvency power, adequately high flash point and suitable volatility at safe temperatures. Examples are chlorocarbons, fluorocarbons and chlorofluorocarbons, the compounds generally containing below 4 carbon atoms, often 1 or 2 carbon atoms.

Accordingly industry has made vast investment in apparatus for cleaning hard surfaces such as circuit boards and soft surfaces such as fabrics with such solvents. Possible environmental disadvantages of the use of such solvents is widely recognised. A very large number of alternative solvents have therefore been investigated, especially in recent years, but none of them have yet proved to be commercially as convenient to operate as the halocarbons which they are intended to replace.

There is therefore an acute need for achieving satisfactory cleaning of articles using a solvent having good solvency power and which is preferably not a volatile halogenated hydrocarbon in such a way that there are substantially no solvent residues on the article and the operatives are not exposed to a flash hazard. Preferably this objective would be achieved with little or no modification of the existing apparatus that is designed for use with, for instance, chlorofluorocarbons.

Amongst the solvents that have been investigated are terpene solvents. Such solvents have been known for a very long time, for instance we are aware that some terpene solvents were commercially available by the early 1940's at least, and possibly earlier. However they have never proved to be of widespread commercial value and part of the problem seems to be that their use resulted in contamination of the article with residues of the terpene solvent, and this contamination rendered the article unacceptable.

The purpose behind the invention therefore is to meet the acute need to provide a method of cleaning dirty articles, which method is environmentally acceptable and that provides articles having a cleanliness that can meet the highest standards, for instance the standards of the electronics industry.

In the invention, a dirty article is contacted with a terpene solvent under conditions that result in cleaning of dirt from the article and in solvent contamination of the article by the terpene solvent, and in this process the solvent contamination is removed by contacting the contaminated article at an elevated temperature with an aqueous medium and azeotropically evaporating the solvent contamination from the surface as an azeotrope with the aqueous medium.

By the invention it is possible to obtain articles having the highest standards of cleanliness but in a manner tht is highly desirable from the environmental point of view. The solvent and water can both be recycled and vapour emissions can be reduced to satisfactorily low values.

The invention is also applicable to other non-halogenated solvents. They can be hydrocarbons, provided the flash hazard is acceptable. The flash point (closed cup) is usually below 150°C and often below 125°C. The solvent can be a mixture and generally most or all of the solvent in the mixture has a flash point below 100°C.

The boiling point of the solvent (which may be a mixture) is generally above 70°C and most usually above 100°C, generally above 130°C. Since the solvent is often a mixture, it will often boil over a range of temperatures, and the boiling point quoted above is the bottom of this range. Generally the boiling point is below 250°C (i.e., the top of the boiling range should be below 250°C). Solvents that boil at temperatures somewhere within the range 150 to 200°C are often preferred.

Other solvents that can be treated in the invention include dibasic esters, such as the materials that are blends of dimethyl succinate, dimethyl adipate and dimethyl glutanate, typically in amounts of, respectively, 15 to 25%, 12 to 23% and 55 to 65%.

The invention, however, is of particular value when, as indicated, the solvent is a terpene solvent, and generally such a solvent comprises at least 50% tepene hydrocarbons with a minor amount of terpene alcohols. Suitable solvents of this type are solvents as described in EP-A-0354027 and the materials that are available from Envirosolv Inc. under the trade name RE-ENTRY, especially RE-ENTRY KNI.

Because terpene solvents are strongly preferred in the invention, both from the point of view of their solvation powers, removability in the invention, and environmental acceptability, the invention is described below by reference to such solvents, but as indicated above similar process steps could be conducted using other solvents.

An essential part of the invention is that the solvent contamination that remains after the terpene cleaning stage is removed azeotropically by forming an azeotrope with the aqueous medium. The azeotrope-forming capabilities of terpene solvents are particularly advantageous, and this constitutes another reason why the terpene solvents are particularly preferred in the invention.

Although adequate results are often achieved as a result of the formation of an azeotrope between the solvent and the water, azeotroping can be promoted, and in particular the azeotroping temperature can be reduced, by including a suitable tertiary solvent. Additionally, the removal of the solvent contamination is promoted if the contamination is spread as a thin film over the article, rather than being concentrated in droplets, and so the presence of a depressant for surface tension is beneficial. Many tertiary solvents that promote the formation of an azeotrope will also help film formation.

These additional solvents should be low boiling solvents so that they are more volatile than the terpene or other main solvent. In general, they should boil at a temperature below the azeotroping temperature, so as to ensure that none of the tertiary solvent remains as a residual contamination. Generally they boil at below 100°C. Various aliphatic compounds such as ketones or, preferably, amines, ethers or alcohols may be used. The total number of carbon atoms in such materials is generally below 8 and preferably each aliphatic group in such compounds contains less than 8, usually 2 to 4, carbon atoms. Particularly preferred materials are propanols and butanols such as isobutanol or, preferably, isopropanol.

Instead of or in addition to including such low boiling solvents to promote film formation, it is also possible to include a surfactant. This should preferably be a volatile surfactant, and in particular it should eb azeotropically volatile.

These additives may be included in the terpene solvent with which the dirty article is initially contacted, and may thus promote the cleaning of the article, typically in an amount of below 10% by weight of the total terpene solvent composition. In other methods, however, the aqueous medium contains the low boiling solvent or other additive. Thus the aqueous medium can consist of water or a mixture of water and the low boiling solvent. The ratio low boiling solvent:water can be from 1:50 to 10:1, generally 1:20 to 1:1.

Although some low boiling, and usually water miscible, organic solvent can be included in the terpene or other cleaning solvent, generally substantially all of this cleaning solvent is immiscible with water. From the environmental and economic point of view, an important feature of the invention is that the azeotrope that is formed between the terpene or other cleaning solvent and the water is condensed and is allowed to phase separate, and the terpene solvent phase is separated and is recycled for subsequent use in cleaning of dirty articles.

The azeotrope is therefore preferably formed by evaporation of the azeotropic mixture (generally at a temperature below 100°C) in a vessel that contains the aqueous medium in its base and that has an outlet for evaporated azeotrope and a condenser across the outlet on which the azeotrope is condensed.

The process is preferably conducted in multistage apparatus comprising one or more solvent-cleaning tank and one or more rinsing tanks including at least one azeotroping tank that has an outlet for volatile gases across which there is a condenser, including means for recovering condensate from the surfaces of the condenser. A solvent cleaning tank is, preferably, an immersion tank, i.e it is designed from immersion of the dirty article in solvent in the tank. If there is more than one solvent cleaning tank, the second tank can be another immersion tank or it can be designed for vapour contact and for recovery of condensed solvent off the article.

The azeotorping tank preferably has a reservoir at its base for containing aqueous medium and a heater for heating the aqueous medium. The condenser across the outlet (often an open top) of the steaming tank may be a cool heat exchanger, for instance cooled by cold water, equipped with means for collecting condensate that condenses on to its outer surfaces. The condenser should be constructed so as essentially to prevent the escape from the tank of any solvent. The condensate will consist of the solvent and generally some water and preferably this is subjected to phase separation with the solvent being recycled to the, or one of the solvent cleaning tanks and with the water either being run to waste or recycled to the steaming tank.

Although it is adequate for the apparatus to consist solely of a liquid solvent tank and a steaming tank, particularly good results can be achieved when the apparatus consists of a liquid solvent tank, a second solvent cleaning tank in which the articles are contacted with vaporised solvent in the presence of steam, and the steaming tank. The inclusion of water with the solvent vapour reduces flammability and so makes safer the vapour cleaning of the articles. The mixed condensate of solvent and water can be recycled to the reservoir of this intermediate tank without phase separation, although usually phase separation is performed so as to facilitate control of the proportions of solvent and water in the reservoir.

A particularly valuable feature of the invention is that the apparatus in which it is performed can be substantially identical to existing ultrasonic cleaning apparatus for use with fluorocarbons and other halogenated, highly volatile, solvents. The only modification that has to be made is that aqueous medium is fed to the final tank in place of the fluorocarbon that previously was fed to that tank for evaporation, the heater in that tank has to have the required heat output and the temperature in the condenser has to be adjusted to condense the solvent (whereas at present it is selected to condense incoming water). When the conventional tank has two vapour phase stages after a liquid immersion tank, it will be necessary to provide means for supplying water also to the reservoir in the second stage.

Contact of the articles with the terpene or other solvent can be vapour contact provided the vessel contains sufficient of an inert gas (for instance carbon dioxide, nitrogen, steam or other oxygen-free gas) to raise the flash point adequately, or the solvent itself has a sufficiently high flash point to cause no flash danger. Generally however contact is by immersion in liquid solvent at a temperature that preferably is well below the flash point, for instance at least $10°C$ and often at least $20°C$ below the flash point of the solvent. The effectiveness of contact can be promoted by mechanical or, preferably, ultrasonic agitation of the solvent.

The azeotroping is preferably conducted at a temperature of below $100°C$. The surface from which azeotropic evaporation is to occur should preferably have an elevated temperature. The article may have been pre-heated (either in the solvent treatment stages or previously) but often the article is heated to the desired azeotroping temperature by contact with the aqueous medium at an elevated temperature. Preferably the temperature of the surface is at least $60°C$, usually at least $80°C$ and preferably at least $95°C$. Best results are achieved if the temperature is 98 or, preferably, $100°C$. The use of such temperatures facilitates removal of final residues of aqueous medium. Indeed it can be desirable to continue contact with hot aqueous medium after substantially all the azeotroping has been completed, primarily to raise the surface to a sufficiently high high temperature as to promote final evaporation of residues of aqueous medium.

A preferred way of performing the contact with the aqueous medium is to contact the contaminated surface with the aqueous medium at a temperature of at least about $98°C$. Preferably therefore the aqueous medium is applied as steam, and this steam can either consist substantially only of water vapour or it can comprise water vapour and a spray of water very near to its boiling point. Thus a boiling water spray (i.e., wet steam) is particularly preferred.

Best results are generally obtained when the azeotropic evaporation of the solvent contamination is conducted while the article is exposed to a gaseous atmosphere. Often therefore the article is held in a stream of steam, and in particular by holding the article above a reservoir containing boiling water or other aqueous medium.

However another method that can be conducted is to immerse the article in hot aqueous medium and then to lift the article out of the medium and allow azeotroping to occur off the surface of the article, due to the elevated temperature of the surface. For instance the aqueous medium can have a temperature of from 60 to $99°C$ and the temperature must be such, having regard to the components in the aqueous medium and the solvent, that azeotroping will occur off the surface when the article is lifted out of the aqueous medium.

In another method, the article (preferably preheated) is immersed in liquid aqueous medium and azeotropic evaporation of the solvent and water (and optionally tertiary solvent) is conducted while the article remains immersed in the liquid.

An advantage of the presence of the aqueous medium, and in particular of processes in which the atmosphere above the aqueous medium is saturated by steam, is that this raises the flash point of the solvent in the ambient atmosphere. In the absence of the steam the solvent would frequently be above its flash point and so simple heating at the temperature of the steaming would be dangerous. However the presence of the steam reduces fire hazard since it excludes oxygen and renders the process safer. An additional purpose that sometimes applies, especially when the steaming includes use of a spray of water very near to its boiling point, is that steam that condenses on to the article will wash off the article water-soluble residues that may not have been removed by the contact with solvent, examples being inorganic salts.

The safety of the process, and the performance, can be improved further by including additional materials in the steam atmosphere either to promote volatilisation of the solvent or to raise the flash point of the combined vapours or both. For instance the flash point of the vapours will be raised if the steaming is conducted in the presence of an inert gas, such as carbon dioxide or nitrogen.

The process of the invention can be applied to the treatment of soft surfaces such as fabrics and other fibrous materials, but preferably is applied to the treatment of hard surfaces such as glass, ceramics and metal. The articles having these surfaces can be, for instance, machined metal parts or, preferably, printed circuit boards. The articles are held in the solvent cleaning tank and the subsequent tank in or on suitable containers, for instance by being suspended from a holder or by being supported in or on a holder, for instance a tray.

The following are non-limitative examples of the invention.

Example 1

This process is conducted in a conventional ultrasonic cleaning apparatus designed for use with fluorocarbons. The apparatus consists of three adjacent tanks. The first tank is constructed to be substantially filled with liquid solvent. The second and third tanks are connected and each have a bottom reservoir provided with a heater for evaporating liquid in the reservoir, so that the articles being cleaned can be subjected to vapour contact with the solvent and solvent can condense on the articles and drain back into the reservoir. All the tanks are open at the top, so as to facilitate the articles being lowered into and drawn up from the liquid or vapour phase. Chilled condenser tubes surround the open outlets of second and third tanks.

In the invention, the solvent is a mixture of a major amount of paramenthadienes, a lesser amount of terpene alcohol and a minor amount of other terpene hydrocarbon that has a flash point typically around 50°C and a distillation range typically somewhere in the range 150 to 200°C and that optionally includes a small amount of isopropanol as a surface tension modifier. The preferred material is sold under the trade name RE-ENTRY KNI by Envirosolv Inc. A tray of metal parts or circuit boards is immersed in the solvent at 35°C for 60 seconds with ultrasonic agitation or sub-surface circulation. The tray is removed from the immersion tank and allowed to drain into the second tank, the reservoir of which contains water (and some solvent) at 98°C. At this temperature the water and solvent azeotropes and the vapour condenses on to the articles and drains back into the reservoir. Carbon dioxide is blown into this tank so as to raise the flash point additionally.

The articles are then transferred to the third tank, the reservoir of which again contains water heated to a temperature sufficient to cause distillation. The heating is preferably conducted for sufficient time for the temperature to reach 100°C, and again carbon dioxide is preferably blown into the tank. Upon removal from this third tank, the articles are free of solvent and water.

Water and solvent are collected from the condensers to the second and third tanks and subjected to phase separation, the solvent being returned to the immersion tank and the water to the final steaming tank.

Example 2

In another example, the second tank can be omitted in which event the solvent is preferably drained from the articles into the immersion tank before being transferred to the steaming tank.

**Claims**

1. A process in which a dirty article is contacted with a non-halogenated organic solvent under conditions that result in cleaning of dirt from the article and in solvent contamination of the article by the non-halogenated solvent, characterised in that the solvent contamination is removed by contacting the contaminated article at an elevated temperature with an aqueous medium and azeotropically evaporating the solvent contamination from the surface as an azeotrope with the aqueous medium.

2. A process according to claim in which the non halogenated solvent is a terpene solvent.

3. A process according to claim 2 in which the terpene solvent comprises at least 50% by weight terpene hydrocarbon, with a lesser amount of terpene alcohol.

4. A process according to any preceding claim in which the azeotrope includes also a low boiling aliphatic organic solvent selected from aliphatic amines, ketones, ethers and alcohols, preferably selected from isopropanol, other propanols, and butanols.

5. A process according to any preceding claim in which the non halogenated solvent includes up to 10% low boiling organic solvent selected from aliphatic amines, ketones, ethers and alcohols.

6. A process according to any preceding claim in which substantially all the non halogenated solvent is immiscible with water, the azeotrope is condensed, the organic solvent phase is separated and the separated phase is recycled for subsequent cleaning of a dirty article.

7. A process according to claim 6 in which the azeotrope is evaporated in a vessel that contains the aqeuous medium in its base and that has a heater for heating the aqueous medium and an outlet for evaporated azeotrope and a condenser across the outlet on which the azeotrope is condensed.

8. A process according to any preceding claim conducted in a multi-stage apparatus comprising a tank for immersion of the dirty article in terpene solvent and a tank in which the azeotrope is evaporated, and including means for condensing the azeotrope, separating the terpene solvent and recycling the terpene solvent to the immersion tank.

9. A process according to any preceding claim in which the elevated temperature at which azeotroping is conducted is from 60 to 100°C.

10. A process according to any preceding claim in which the aqueous medium has a temperature of at least 98°C.

11. A process according to any preceding claim in which the aqueous medium is steam.

12. A process according to claim 12 in which the steam comprises water vapour and a spray of water at a temperature of at least about 98°C.

13. A process according to any preceding claim in which azeotropic evaporation of the solvent contamination is conducted while the article is exposed to a gaseous atmosphere.

14. A process according to any of claims 1 to 10 in which the contact with the aqueous medium is by immersion of the article in the aqueous medium in liquid form, and the article is then withdrawn from the liquid aqueous medium to permit azeotropic evaporation to occur.

15. A process according to any of claims 1 to 10 in which the azeotropic evaporation of the solvent contamination is conducted while the article is immersed in the aqueous medium in liquid form.

16. A process according to any preceding claim in which the aqueous medium comprises a low boiling aliphatic solvent selected from aliphatic amines, ketones, ethers and alcohols, preferably selected from isopropanol, other propanols and butanols.

17. A process according to claim 1 in which the organic solvent is a dibasic ester.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 104 633 (HONEYWELL INC.)<br>* Page 3, lines 13-33; page 4, lines 16-18; page 7, line 28 - page 8, line 7; figures 2,4 *<br>— — — | 1,4-8, 13-16 | C 23 G 5/02 |
| A | EP-A-0 302 313 (WEIL)<br>* Abstract; fig. *<br>— — — | 1,4-8, 13-16 | |
| A | WO-A-8 700 209 (PETROFERM USA)<br>* Claims 1,2 *<br>— — — | 1-5 | |
| A | WORLD PATENT INDEX, FILE SUPPLIER, abstract AN = 87-089973, Derwent Publications Ltd, London, GB;<br>& JP-A-62 039 699 (JOHNSON) 20-02-1987<br>* Abstract *<br>— — — — — | 1 | |
| | | | **TECHNICAL FIELDS SEARCHED (Int. Cl.5)** |
| | | | C 23 G<br>C 11 D |

The present search report has been drawn up for all claims

| Place of search | Date of completion of search | Examiner |
|---|---|---|
| The Hague | 12 December 90 | ASHLEY G.W. |